# EUROPÄISCHE PATENTANMELDUNG

(11) **EP 3 444 220 A1**
(43) Veröffentlichungstag der Anmeldung: **20.02.2019**
(21) Anmeldenummer: 18188804.1
(22) Anmeldetag: 14.08.2018
(51) Int. Cl.: B66F 9/07, B65G 15/26, B66F 9/14, B25J 18/02, H01L 21/677

(54) **LINEARE AUSZUGSEINHEIT**

(30) Priorität: 14.08.2017 AT 506732017
(71) Anmelder: Muser, Josef, 8073 Neu-Seiersberg (AT)
(72) Erfinder: Muser, Josef, 8073 Neu-Seiersberg (AT)
(74) Vertreter: Babeluk, Michael

(57) **Zusammenfassung**

Die Erfindung betrifft eine lineare Auszugseinheit (1), insbesondere für einen Roboter (5), mit zumindest einem Teleskopauszug (5), welcher zumindest eine Führungsschiene (2, 3) und zumindest einen Hubwagen (4, 5, 6) aufweist, wobei die Führungsschiene (2; 3) und der Hubwagen (4, 5; 6) relativ zueinander in einer Verschieberichtung (x) verschiebbar zueinander angeordnet sind.

Um mit möglichst geringer Baulänge große Hubwege zu realisieren und dabei eine präzise und zuverlässige Führung zu gewährleisten und einen ausfallsarmen Betrieb zu ermöglichen, ist vorgesehen, dass der Teleskopauszug (5) dreistufig ausgebildet ist, wobei die erste Stufe (9) eine erste Führungsschiene (2), die zweite Stufe (10) eine zweite Führungsschiene (3) und die dritte Stufe (11) einen dritten Hubwagen (6) aufweist.

## Beschreibung

Die Erfindung betrifft eine lineare Auszugseinheit, insbesondere für einen Roboter, mit zumindest einem Teleskopauszug, welcher zumindest eine Führungsschiene und zumindest einen Hubwagen aufweist, wobei die Führungsschiene und der Hubwagen relativ zueinander in einer Verschieberichtung verschiebbar zueinander angeordnet sind.

Lineare Auszugseinheiten weisen üblicherweise Hubwagen mit Kugel- oder Rollenumlauflagerungselementen auf.

Aus der AT 505 757 B1 ist ein Manipulationsgerät zum Be- und Entladen eines Regals mit einem einen Hubwagen aufweisenden Teleskopauszug bekannt, welcher einen ersten Teleskopteil und einen zweiten Teleskopteil aufweist. Der erste Teleskopteil ist mit dem Hubwagen und der zweite Teleskopteil mit dem ersten Teleskopteil in einer im Wesentlichen horizontalen Verschieberichtung verschiebbar verbunden. Der Hubwagen weist eine Wälzlagereinheit und eine von dieser beabstandete Stützrolle auf.

Aus der WO 03/040021 A1 ist eine Vorrichtung zur transversalen Bewegung eines Lastaufnahmemittels in einem flurfreien System zum Bedienen von Lagereinheiten bekannt, welche aus einer horizontal verschiebbaren Bühne besteht, an der teleskopartig ineinandergreifende Schubelemente so ausgestaltet sind, dass in einem ersten Zustand eine Baugröße vorliegt, die im Wesentlichen der Baugröße des größten Schubelementes entspricht. Im ausgefahrenen Zustand ragen die Schubelemente wesentlich über eine Seite der Bühne hinaus.

Aus der DE 100 65 084 A1 ist ein Teleskopförderer zur horizontalen Handhabung von Lasten bekannt, welcher ein Basisprofil und ein Mittelprofil aufweist, welche aus kostengünstigen Formprofilen bestehen.

Die EP 1 431 237 A1 beschreibt ein Lasttraggestell für ein Regalbediengerät mit einem auf einem Hubschlitten des Fördergerätes befestigbaren Traggestell und mit auf diesem parallel zueinander angeordneten Tragvorrichtungen mit verfahrbaren Teleskop-Tragarmen zur Aufnahme eines Ladehilfsmittels, wie Palette, Box, etc. Weiters weist das Lasttraggestell eine zur Verstellrichtung der Tragvorrichtungen parallel verlaufende Fördereinrichtung auf, welche durch zwei Fördervorrichtungen gebildet ist, die jeweils zwei in Bezug auf eine zwischen den Tragvorrichtungen senkrecht zu einer Aufstandsfläche des Regalbediengerätes verlaufenden Mittelebene symmetrisch angeordnete Linearförderer umfassen, die eine zu einer Verstellrichtung der Tragvorrichtungen parallele Förderrichtung ausbilden. Zur Mittelebene senkrecht verlaufende Mittelabstände der Linearförderer sind dabei größer als ein Mittelabstand der Tragvorrichtungen.

Bekannte Manipulationsgeräte sind als zwei- bis dreistufige Teleskope ausgeführt, welche über Rollen geführt werden. Rollen können mit sehr großen Lagerabständen montiert werden, da sie ihre Führungsnut auch verlassen können. Um die geforderte Steifigkeit zu gewährleisten und das Spiel der Auszüge zu reduzieren mussten bisher aufwendig Nutenlaufbahnen mit genauen Toleranzen gefräst werden. Beim Einsatz in Bearbeitungszentren ergibt sich zusätzlich das Problem, dass extrem viele Metallspäne anfallen, weshalb aufwendige spezielle Abstreifsysteme erforderlich sind.

Aus dem Gebiet der Werkzeugmaschinen ist es bekannt, Profilschienen-Wälzlagerführungen einzusetzen, welche weniger anfällig für Verschmutzung durch Metallspäne sind.

Aus der DE 43 31 511 C2 ist eine Profilschienenkugelumlaufführung mit einem Wagen bekannt, der mit Führungsschenkeln eine mit einem verbreiterten Kopf versehene Führungsschiene auf gegenüberliegenden Seiten und von oben umgreift, wobei der Wagen über zwischen den Führungsschenkeln und der Führungsschiene angeordnete Kugeln linear beweglich geführt ist.

Die DE 33 38 751 A1 beschreibt ein lineares Wälzlager, das zur Führung einer hin- und hergehenden Bewegung mit hoher Geschwindigkeit geeignet ist. Das lineare Wälzlager umfasst einen Lagerkäfig, der aus einem leichten Material, zum Beispiel aus Kunstharz oder Aluminium ausgebildet ist.

Weiters ist aus der DE 103 12 008 A1 eine Linearantriebseinheit mit einem ersten Maschinenteil und einem zweiten Maschinenteil bekannt, wobei zwischen den beiden Maschinenteilen ein erstes Linearwälzlager angeordnet ist. Ein erster Führungswagen des ersten Linearwälzlagers ist auf einer ersten Zahnstangenschiene wälzgelagert, wobei mit der ersten Zahnstangenschiene ein erstes Antriebsritzel kämmt.

Dreistufige Teleskopauszüge mit Führungswägen würden bei Ausnutzung der Teleskopträgerlängen von Linearführungsschienen herunterfahren und bei der Rückfahrt wieder auf die Schiene auffahren. Die ist aber mit herkömmlicher Lineartechnik nicht machbar und würde nach kurzer Zeit zur Zerstörung führen. Bekannte dreifach-Auszüge sind daher nicht mit Linearrollen/kugel-Schienen, sondern mit Schwerlastrollen ausgeführt.

Aufgabe der Erfindung ist es, mit möglichst geringer Baulänge große Hubwege zu realisieren und dabei eine präzise und zuverlässige Führung zu gewährleisten und einen ausfallsarmen Betrieb zu ermöglichen.

Erfindungsgemäß wird diese Aufgabe mit einer eingangs genannten linearen Auszugseinheit gelöst, bei der der Teleskopauszug dreistufig ausgebildet ist, wobei die erste Stufe eine erste Führungsschiene, die zweite Stufe eine zweite Führungsschiene und die dritte Stufe einen dritten Hubwagen aufweist.

Vorzugsweise ist vorgesehen, dass ein erster Hubwagen in oder an der ersten Führungsschiene verschiebbar gelagert ist, wobei vorzugsweise der erste Hubwagen mit einem Gehäuse oder einem Roboter fest verbindbar ist. Weiters ist in einer Ausführung der Erfindung vorgesehen, dass ein mit der zweiten Führungsschiene fest verbundener zweiter Hubwagen in oder an der ersten Führungsschiene, vorzugsweise an einer dem ersten Hubwagen abgewandten Längsseite der ersten Führungsschiene, verschiebbar gelagert ist.

Besonders vorteilhaft ist es, wenn der zweite Hubwagen mit einem mittigen Bereich der zweiten Führungsschiene fest verbunden ist. Dies ermöglicht es, den Teleskopauszug in einer ersten und in einer dieser entgegengesetzten Verschieberrichtung gleich weit auszuziehen, bis die durch die drei Stufen definierte maximale Verschiebelänge erreicht ist.

Eine Ausführungsvariante der Erfindung sieht vor, dass der dritte Hubwagen - vorzugsweise an einer dem zweiten Hubwagen abgewandten Längsseite der zweiten Führungsschiene - in oder an der zweiten Führungsschiene verschiebbar gelagert ist.

In einer vorteilhaften Ausführung der Erfindung ist vorgesehen, dass die erste Führungsschiene ein erstes Zugmittel aufweist, welches einerseits mit dem ersten Hubwagen und andererseits - vorzugsweise über einen ersten Mitnehmerteil - mit der zweiten Führungsschiene fest verbunden ist. Vorzugsweise weist das erste Zugmittel zwei Enden auf, wobei zumindest eines der Enden mit einer im oder am ersten Hubwagen angeordneten ersten Spanneinrichtung verbunden ist.

Eine weitere vorteilhafte Ausführung der Erfindung sieht vor, dass die zweite Führungsschiene ein zweites Zugmittel aufweist, welches einerseits - vorzugsweise über einen zweiten Mitnehmerteil - mit der ersten Führungsschiene und andererseits mit dem dritten Hubwagen fest verbunden ist. Vorzugsweise weist das zweite Zugmittel zwei Enden auf, wobei zumindest eines der Enden mit einer im oder am dritten Hubwagen angeordneten zweiten Spanneinrichtung verbunden ist.

In einer platzsparenden und einfachen Ausführung der Erfindung ist vorgesehen, dass die Auszugseinheit einen Teleskopauszug aufweist, wobei vorzugsweise der dritte Hubwagen des Teleskopauszugs mit einer Manipulationseinrichtung verbunden sind. Bei dieser Variante ist nur eine Betätigungseinrichtung als Antrieb erforderlich, welche auf die einzige erste Führungsschiene einwirkt.

Eine weitere vorteilhafte Ausführung der Erfindung sieht vor, dass die Auszugseinheit zumindest zwei Teleskopauszüge aufweist, wobei vorzugsweise die Teleskopauszüge symmetrisch zu einer parallel zur Verschieberichtung ausgebildeten Symmetrieebene angeordnet sind.

Eine die Auszugseinheit zumindest zwei Teleskopauszüge aufweist, wobei vorzugsweise die Teleskopauszüge symmetrisch zu einer parallel zur Verschieberichtung ausgebildeten Symmetrieebene angeordnet sind. Vorteilhafterweise sind die dritte Hubwagen der beiden Teleskopauszüge mit einer Manipulationseinrichtung verbunden sind., wobei vorzugsweise die Manipulationseinrichtung im Bereich der Symmetrieebene zwischen den dritten Hubwagen angeordnet sind. Diese Variante erlaubt auch bei relativ großen Kräften und/oder schweren Lasten eine präzise Führung. Dabei wirkt bevorzugt auf jede erste Führungsschiene jeweils eine Betätigungseinrichtung ein, um eine parallele Führung und einen gleichmäßigen Auszug der Auszugseinheit ohne die Gefahr eines Verkantens zu ermöglichen.

Die Manipulationseinrichtung kann beispielsweise durch eine Plattform, einen Greifer oder sonstiges Handhabungselement gebildet sein.

Die Erfindung wird im Folgenden an Hand der in den Figuren gezeigten nicht einschränkenden Ausführungsbeispiele näher erläutert. Darin zeigen:
- Fig. 1: eine erfindungsgemäße Auszugseinheit in einer Schrägansicht in einer ausgezogenen Position;
- Fig. 2: diese Auszugseinheit in einer Draufsicht;
- Fig. 3: diese Auszugseinheit in einer Vorderansicht;
- Fig. 4: diese Auszugseinheit in einem Schnitt gemäß der Linie IV - IV in Fig. 3 in einer eingezogenen Position; und
- Fig. 5: die Auszugseinheit in einer schematischen Ansicht in einer Endlage.

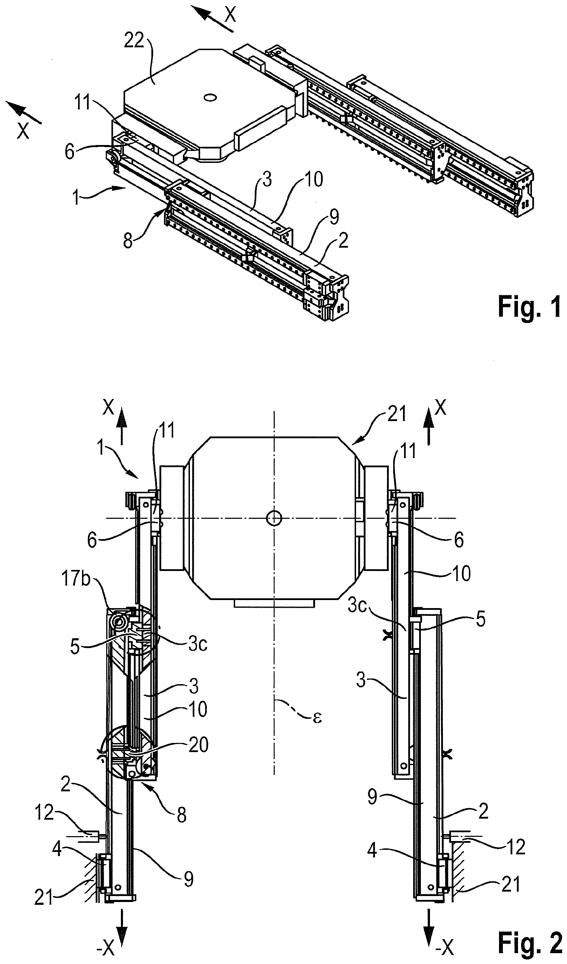

Fig. 1 bis Fig. 4 zeigen jeweils eine lineare Auszugseinheit 1 mit einer ersten Führungsschiene 2 und einer zweiten Führungsschiene 3, wobei die Führungsschienen 2, 3 über Hubwagen 1, 6, 5 teleskopartig linear verschiebbar miteinander verbunden und über nicht weiter dargestellte Lagereinrichtungen gegeneinander gelagert sind. Die erste Führungsschiene 2 weist zumindest einen ersten Hubwagen 1 auf, welcher mit einem durch Bezugszeichen 20 angedeuteten Roboter, beispielsweise einem Roboterarm, verbunden ist.

Die erste Führungsschiene 2 ist beweglich mit dem ersten Hubwagen 4 verbunden, wobei die erste Führungsschiene 2 am ersten Hubwagen 4 bzw. der erste Hubwagen 4 an der ersten Führungsschiene 2 geführt ist, sodass die erste Führungsschiene 2 relativ zum ersten Hubwagen 4 in der Verschieberichtung x verschiebbar ist. Die zweite Führungsschiene 3 ist - ebenfalls in der Verschieberichtung x - verschiebbar über einen zweiten Hubwagen 5 mit der ersten Führungsschiene 2 verbunden, wobei der zweite Hubwagen 5 auf der zweiten Führungsschiene 3 in einem - bezogen auf die Längserstreckung der Führungsschiene 3 in Verschieberichtung x - etwa mittigen Bereich 3c angeordnet und fest mit dieser verbunden ist. Durch die mittige Anordnung des zweiter Hubwagens 5 ist der Teleskopauszug 8 sowohl in der Verschieberichtung x, als auch in der Gegenrichtung verschiebbar. Der zweiter Hubwagen 5 ist gleitend oder rollend an der ersten Führungsschiene 2 gelagert. Auf der der ersten Führungsschiene 2 bzw. dem erster Hubwagen 4 abgewandten Seite ist ein in oder entgegen der Verschieberichtung x, -x verfahrbarer dritter Hubwagen 6 mit der zweiten Führungsschiene 3 verschiebbar verbunden. Mit dem dritten Hubwagen 6 kann über eine Anbauplatte 7 eine Manipulationseinrichtung 21, wie beispielsweise ein Palettentisch, eine Greifervorrichtung oder ähnliche Handhabungseinrichtungen, verbunden werden. Die Lagerungen zwischen erstem Hubwagen 4 und erster Führungsschiene 2, zwischen dem zweiten Hubwagen 5 und der ersten Führungsschiene 2, sowie zwischen dem dritten Hubwagen 6 und der zweiten Führungsschiene 3 kann beispielsweise über herkömmliche Rollen- oder Kugellager erfolgen, wobei für den ersten Hubwagen 4, den zweiten Hubwagen 5 und den dritter Hubwagen 6 auch jeweils zumindest ein konventioneller Kugel-/ oder Rollenumlaufwägen eingesetzt werden können. Es ist auch möglich für den ersten Hubwagen 4, den zweiten Hubwagen 5 und den dritten Hubwagen 6 zwei Kugel-/ oder Rollenumlaufwägen einzusetzen.

Die erste Führungsschiene 2, die zweite Führungsschiene 3 und der dritte Hubwagen 6 bilden einen dreistufigen Teleskopauszug 8, wobei die erste Stufe 9 durch die erste Führungsschiene 2, die zweite Stufe 10 durch die zweite Führungsschiene 3 und die dritte Stufe 11 durch den dritter Hubwagen 6 gebildet werden.

Der Antrieb des Teleskopauszuges 8 erfolgt mittels einer auf die erste Führungsschiene 2 wirkenden Betätigungseinrichtung 12, beispielsweise einen Elektromotor, welcher über ein mit einer Zahnstange kämmendes Ritzel auf die erste Führungsschiene 2 einwirkt, wobei die Zahnstange mit der ersten Führungsschiene 2 fest verbunden ist und der Elektromotor fest mit dem ersten Hubwagen 4 verbunden ist. Die erste Führungsschiene 2 weist ein erstes Zugmittel 13 und die zweite Führungsschiene 3 ein zweites Zugmittel 14 auf. Die Zugmittel 13, 14 können beispielsweise Zahnriemen, Ketten oder Seile sein. Die Zugmittel 13, 14 können endlos ausgeführt sein oder beispielsweise in einer Spannvorrichtung 15, 16 eingespannte Enden 13a, 13b; 14a, 14b aufweisen. Die Zugmittel 13, 14 werden über drehbar im Bereich der Schienenenden 2a, 2b; 3a, 3b der jeweiligen Führungsschienen 2, 3 gelagerte Rollen 17a, 17b; 18a, 18b umgelenkt.

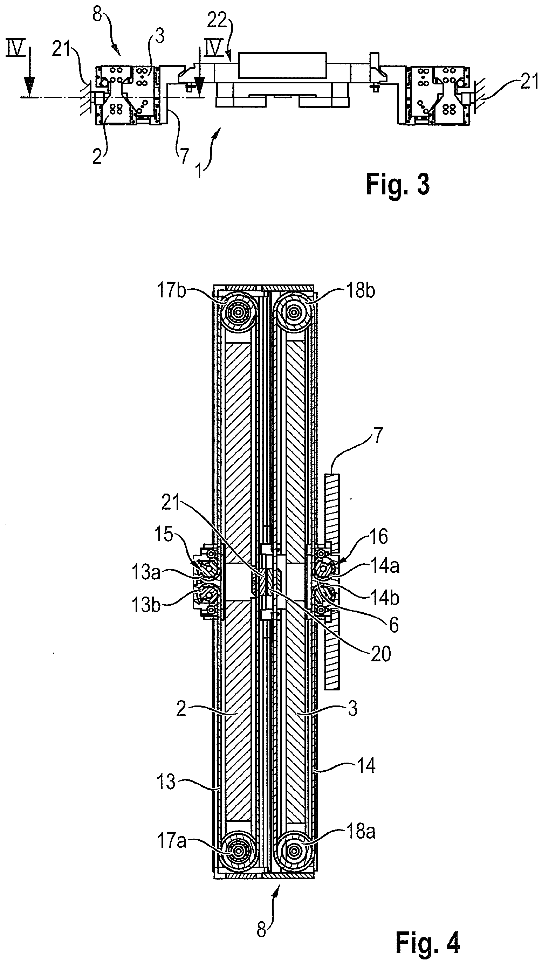

In den Fig. 1, Fig. 2 und Fig. 5 ist die Auszugseinheit 1 in einer ausgezogenen Position und in Fig. 4 in einer eingezogenen Position dargestellt.

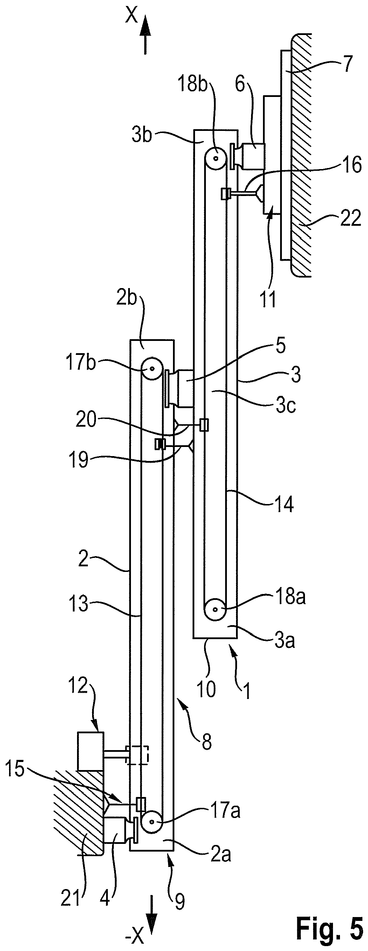

Wie insbesondere aus Fig. 5 hervorgeht, ist das erste Zugmittel 13 einerseits über die erste Spannvorrichtung 15 mit dem ersten Hubwagen 4 bzw. der Roboter 21 und andererseits über einen ersten Mitnehmerteil 19 mit der zweiten Führungsschiene 3 fest verbunden. Das zweite Zugmittel 14 ist einerseits über einen zweiten Mitnehmerteil 20 mit der ersten Führungsschiene 2 und andererseits über die zweite Spannvorrichtung 16 mit dem dritter Hubwagen 6 fest verbunden. Diese "festen" Verbindungen können durch Klemm- oder Formschlussverbindungen der Mitnehmerteile 19, 20 erfolgen.

Wird die erste Führungsschiene 2 durch die Betätigungseinrichtung 12 in Verschieberichtung x oder entgegen dazu bewegt, so kommt es zu einem Abwälzen des fest mit dem ersten Hubwagen 4 verbundenen ersten Zugmittels 13. Dadurch wird die mit dem ersten Zugmittel 13 verbundene zweite Führungsschiene 3 doppelt so schnell wie die erste Führungsschiene 2 in Richtung x bzw. entgegen -x bewegt. Durch die Bewegung der zweiten Führungsschiene 3 kommt es weiters zu einem Abwälzen des fest über den zweiten Mitnehmerteil 20 mit der ersten Führungsschiene 2 verbundenen zweiten Zugmittels 14. Dadurch wird der mit dem zweiten Zugmittel 14 verbundene dritter Hubwagen 6 doppelt so schnell wie die zweite Führungsschiene 3 in Richtung x bzw. entgegen bewegt.

Mit der beschriebenen linearen Auszugseinheit 1 lassen sich mit sehr geringer Baulänge hohe Hublängen erreichen.

## Patentansprüche

1. Lineare Auszugseinheit (1), insbesondere für einen Roboter (21), mit zumindest einem Teleskopauszug (5), welcher zumindest eine Führungsschiene (2, 3) und zumindest einen Hubwagen (4, 5, 6) aufweist, wobei die Führungsschiene (2; 3) und der Hubwagen (4, 5; 6) relativ zueinander zumindest in einer Verschieberichtung (x) verschiebbar zueinander angeordnet sind, **dadurch gekennzeichnet, dass** der Teleskopauszug (5) dreistufig ausgebildet ist, wobei die erste Stufe (9) eine erste Führungsschiene (2), die zweite Stufe (10) eine zweite Führungsschiene (3) und die dritte Stufe (11) einen dritten Hubwagen (6) aufweist.

2. Auszugseinheit (1) nach Anspruch 1, **dadurch gekennzeichnet, dass** ein erster Hubwagen (4) in oder an der ersten Führungsschiene (2) verschiebbar gelagert ist, wobei vorzugsweise der erste Hubwagen (4) mit einem Gehäuse oder einem Roboter (5) fest verbindbar ist.

3. Auszugseinheit (1) nach Anspruch 1 oder 2, **dadurch gekennzeichnet, dass** ein mit der zweiten Führungsschiene (3) fest verbundener zweiter Hubwagen (5) in oder an der ersten Führungsschiene (2), vorzugsweise an einer dem ersten Hubwagen (4) abgewandten Längsseite der ersten Führungsschiene (2), verschiebbar gelagert ist.

4. Auszugseinheit (1) nach Anspruch 3, **dadurch gekennzeichnet, dass** der zweite Hubwagen (4) mit einem mittigen Bereich (3c) der zweiten Führungsschiene (3) fest verbunden ist.

5. Auszugseinheit (1) nach einem der Ansprüche 1 bis 4, **dadurch gekennzeichnet, dass** dritte Hubwagen (6) - vorzugsweise an einer dem zweiten Hubwagen (5) abgewandten Längsseite der zweiten Führungsschiene (3) - in oder an der zweiten Führungsschiene (3) verschiebbar gelagert ist.

6. Auszugseinheit (1) nach einem der Ansprüche 1 bis 5, **dadurch gekennzeichnet, dass** die erste Führungsschiene (2) ein erstes Zugmittel (13) aufweist, welches einerseits mit dem ersten Hubwagen (4) und andererseits - vorzugsweise über einen ersten Mitnehmerteil (19) - mit der zweiten Führungsschiene (3) fest verbunden ist.

7. Auszugseinheit (1) nach Anspruch 6, **dadurch gekennzeichnet, dass** das erste Zugmittel (13) zwei Enden (13a, 13b) aufweist, wobei zumindest eines der Enden (13a; 13b) mit einer im oder am ersten Hubwagen (4) angeordneten ersten Spanneinrichtung (15) verbunden ist.

8. Auszugseinheit (1) nach einem der Ansprüche 1 bis 7, **dadurch gekennzeichnet, dass** die zweite Führungsschiene (3) ein zweites Zugmittel (14) aufweist, welches einerseits - vorzugsweise über einen zweiten Mitnehmerteil (20) - mit der ersten Führungsschiene (2) und andererseits mit dem dritten Hubwagen (6) fest verbunden ist.

9. Auszugseinheit (1) nach Anspruch 8, **dadurch gekennzeichnet, dass** das zweite Zugmittel (14) zwei Enden (14a, 14b) aufweist, wobei zumindest eines der Enden (14a; 14b) mit einer im oder am dritten Hubwagen (6) angeordneten zweiten Spanneinrichtung (16) verbunden ist.

10. Auszugseinheit (1) nach einem der Ansprüche 1 bis 9, **dadurch gekennzeichnet, dass** die Auszugseinheit (1) einen Teleskopauszug (8) aufweist, wobei vorzugsweise der dritte Hubwagen (6) des Teleskopauszugs (8) mit einer Manipulationseinrichtung (22) verbunden sind.

11. Auszugseinheit (1) nach einem der Ansprüche 1 bis 9, **dadurch gekennzeichnet, dass** die Auszugseinheit (1) zumindest zwei Teleskopauszüge (8) aufweist, wobei vorzugsweise die Teleskopauszüge (8) symmetrisch zu einer parallel zur Verschieberichtung (x) ausgebildeten Symmetrieebene (ε) angeordnet sind.

12. Auszugseinheit (1) nach Anspruch 11, **dadurch gekennzeichnet, dass** die dritten Hubwagen (6) der Teleskopauszüge (8) mit einer Manipulationseinrichtung (22) verbunden sind., wobei vorzugsweise die Manipulationseinrichtung (22) im Bereich der Symmetrieebene (ε) zwischen den dritten Hubwagen (6) angeordnet sind.

13. Auszugseinheit (1) nach einem de Ansprüche 10 bis 12, **dadurch gekennzeichnet, dass** die Manipulationseinrichtung (22) durch einen Palettentisch, einen Greifer oder dergleichen gebildet ist.
